Europäisches Patentamt

European Patent Office

Office européen des brevets

(19)

(11) Veröffentlichungsnummer: **0 390 936 B1**

# (12) EUROPÄISCHE PATENTSCHRIFT

(45) Veröffentlichungstag der Patentschrift: **26.05.93**

(51) Int. Cl.5: **G01D 5/245**, H03M 1/30

(21) Anmeldenummer: **89105645.9**

(22) Anmeldetag: **30.03.89**

(54) **Schaltungsanordnung mit einem Gebersystem für weg- bzw. winkelabhängige Signale.**

(43) Veröffentlichungstag der Anmeldung:
**10.10.90 Patentblatt 90/41**

(45) Bekanntmachung des Hinweises auf die
Patenterteilung:
**26.05.93 Patentblatt 93/21**

(84) Benannte Vertragsstaaten:
**CH DE FR GB IT LI**

(56) Entgegenhaltungen:
**EP-A- 0 325 981**
**DE-A- 3 126 047**
**DE-A- 3 218 101**
**FR-A- 2 234 550**

**PATENT ABSTRACTS OF JAPAN, Band 37,**
**Nr. 61 (P-130), 24. Juli 1982; & JP-A-57 059**
**116 (SAKATA DENKI K.K.) 09-04-1982**

**N.T.I.S. TECHNICAL NOTES, Nr. 11, Part B,**
**November 1984, Seite NTMB4-0999, Spring-**
**field, Virginia, US; J.R. CURRIE et al.:**
**"Circuitry for angle measurements"**

(73) Patentinhaber: **SIEMENS AKTIENGESELL-**
**SCHAFT**
**Wittelsbacherplatz 2**
**W-8000 München 2(DE)**

(72) Erfinder: **Donat, Albrecht, Dipl.-Ing. (Univ.)**
**Buchenbacher Anlage 5**
**W-8520 Erlangen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.6/3.3.1)

## Beschreibung

Die Erfindung bezieht sich auf eine Schaltungsanordnung gemäß dem Oberbegriff des Patentanspruchs 1.

Insbesondere zur Erfassung von Rotationsbewegungen von Maschinenteilen sind digitale Inkrementalgeber mit angenähert sinusförmigen Ausgangssignalen, die einen Phasenversatz von 90° el. aufweisen, handelsüblich. Wenn diese Gebersignale auszuwerten sind, läßt sich eine dazu erforderliche Signalverarbeitung dadurch erleichtern, daß ein linearer Zusammenhang zwischen Weg bzw. Winkel und einem von den Gebersignalen abgeleiteten Folgesignal erreicht wird. Eine Schaltungsanordnung hierzu ist aus der DE – A 3 218 101 bekannt. Dabei wird aus den Gebersignalen durch Gleichrichtung und Minimalwertbildung ein näherungsweise dreieckförmiges Signal erzeugt, dessen Amplitude einen linearen Zusammenhang zur Position innerhalb einer jeden Achtelperiode des Gebers hat. Ferner sind außer den Gleichrichterstufen auch Schaltungselemente nach Art von Summierstufen und quotientenbildenden Umsetzern vorhanden. Durch Analog – Digital – Wandlung und Verknüpfung mit Komparatorsignalen, die die richtige Achtelperiode auswählen, wird die Unterteilung der Geberperiode erleichtert. Bei dieser Einrichtung ist jedoch ein gewisse Empfindlichkeit gegenüber Fehlern der Gebersignale, d.h. Fehler der Amplitudengleichheit, Phasenund Offsetfehler, gegeben.

In der älteren, nicht vorveröffentlichten EP – A1 – 0 325 981 ist eine Schaltungsanordnung beschrieben, die ebenfalls mit zwei um 90° el. phasenverschoben weg – bzw. winkelabhängigen sinusförmigen Signalen gleicher Amplitude und Periode arbeitet, wobei jedoch eine relativ große Unempfindlichkeit gegenüber den obengenannten Verfälschungen der Gebersignale besteht. Bei dieser Schaltungsanordnung ist jedoch die Auflösung auf zwei Dreiecksverläufe, d.h.vier lineare Abschnitte, innerhalb einer Periode begrenzt.

Aufgabe der Erfindung ist, eine Schaltungsanordnung der eingangs genannten Art zu schaffen, bei der mit geringem technischen Aufwand ein linearer Zusammenhang zwischen Weg bzw. Winkel und einem aus den Gebersignalen gewonnenen Folgesignal besteht. Dabei soll zum einen für die Gebersignale ein möglichst großer Toleranzbereich zulässig sein und zum anderen soll eine möglichst hohe Auflösung der linearen Signale erreicht werden.

Diese Aufgabe wird durch die Erfindung gemäß Patentanspruch 1 gelöst.

Eine erste vorteilhafte Ausbildung der Erfindung ist dadurch gekennzeichnet, daß verbleibende Nichtlinearitäten des resultierenden Folgesignals durch eine Signalumsetzung entsprechend einer der Nichtlinearität angepaßten Kennlinie reduzierbar sind. Dabei kann der an sich schon sehr kleine systembedingte Meßfehler den Erfordernissen entsprechend nochmals reduziert werden. Die Kennlinie kann in technisch ausgesprochen einfacher Weise durch eine geknickte Kennlinie realisiert werden. In diesem Zusammenhang erweist es sich als vorteilhaft, daß die Signalumsetzung vor dem den Quotienten bildenden Umsetzer erfolgt. Damit wird eine Signalumsetzung im Analogbereich ermöglicht, was technisch relativ einfach zu bewerkstelligen ist.

Dadurch, daß das resultierende dreieckförmige Folgesignal durch Spiegelung des jeweils auf – bzw. absteigenden Signalzugs in ein sägezahnförmiges Folgesignal umformbar ist, ergibt sich eine ausgesprochen einfache weitere Signalauswertung, da die Signalverläufe dann in den aufeinanderfolgenden Achtelperioden von gleicher Form sind.

Ein Ausführungsbeispiel der Erfindung ist in der Zeichnung dargestellt und wird im folgenden näher erläutert. Dabei zeigen:

FIG 1 ein Blockschaltbild und

FIG 2 einige signifikante Signalverläufe.

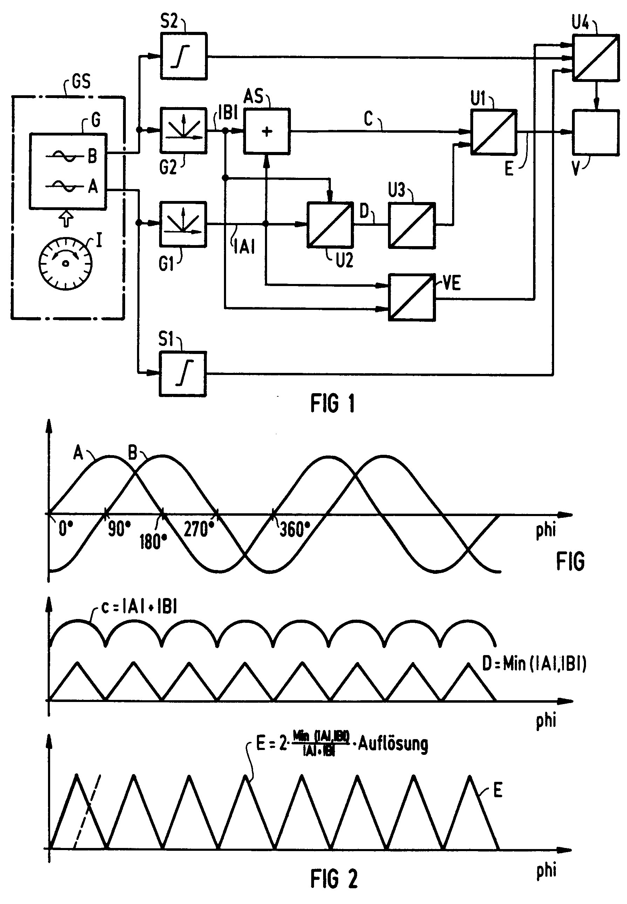

In der Darstellung gemäß FIG 1 ist ein Gebersystem GS zur Aufnahme von Drehbewegungen gezeigt, bei dem eine Impulsscheibe I mechanisch entsprechend der zu erfassenden Drehbewegung bewegt wird und wobei ein Geber G über zwei der Übersichtlichkeit halber nicht dargestellte Aufnahmeköpfe zwei um 90° el. zueinander phasenverschobene winkelabhängige sinusförmige Signale gleicher Amplitude und Periode entsprechend der Abfolge der Impulsmarken der Impulsscheibe I liefert. Die Signale des Gebers G seien dabei mit A und B bezeichnet.

Das Signal A wird mit Hilfe eines Gleichrichters G1 gleichgerichtet, an dessen Ausgang demzufolge jeweils ein dem Betrag des Signals A entsprechendes Signal |A| vorliegt. Das Signal B wird einem Gleichrichter G2 zugeführt, der das Signal B ebenfalls in ein dem Betrag des Signals B entsprechendes Ausgangssignal |B| umformt. Die Signale |A| und |B| werden einer Addierstufe AS zugeleitet, die ein der Summe |A| + |B| der Beträge |A| und |B| der Signale A und B entsprechendes Ausgangssignal, im folgenden Signal C genannt, bildet. Dieses Signal C gelangt an den ersten Eingang eines Umsetzers U1.

Die Signale |A| und |B| gelangen ferner an den Eingang eines Umsetzers U2, der jeweils das kleinere der beiden Signale |A| und |B| an seinen Ausgang als Signal D durchschaltet. Dieses Signal D wird über einen Umsetzer U3, auf dessen Funktion im folgenden noch eingegangen wird, an den zweiten Eingang des Umsetzers U1 geleitet. Vom Umsetzer U1 wird in digitaler Form ein Ausgangssignal E gebildet, das sich ergibt als

$$E = 2 \cdot (Min\ (|A|,|B|)/(|A| + |B|)) \cdot Auflösung$$

Die Auflösung entspricht dabei den maximalen Ausgangswert, z.B. $2^8$, des Umsetzers U1. Das Signal E würde dann eine Breite von 8 bit aufweisen.

Die von der Drehbewegung der Impulsscheibe I abhängigen Signale A und B des Gebers G sind im oberen Diagramm von FIG 2 dargestellt. Bei einer angenommenen Drehrichtung im Uhrzeigersinn folgt dabei das Signal B, das eine gleiche Amplitude und eine gleiche Periode wie das Signal A aufweist, diesem mit einer Verzögerung von 90° el. Im oberen Diagramm sind außerdem die Grenzen der signifikanten Viertelperioden, d.h. die Werte des Winkels phi von 0°, 90°, 180°, 270° und 360°, bezeichnet.

Im mittleren Diagramm von FIG 2 ist im gleichen Maßstab wie im oberen Diagramm das Summensignal der Beträge des Signals A und B also das Signal C = |A| + |B| dargestellt. Ferner ist im mittleren Diagramm der Verlauf des Signals D = Min (|A|,|B|) gezeigt. Dieses dreieckförmige Signal D ist idealisiert dargestellt, da davon auszugehen ist, daß bei Schwankungen der Signale A und B die Amplitude dieses Signals variiert.

Im unteren Diagramm von FIG 2 ist gezeigt, daß das Signal E auf einen dreieckförmigen Verlauf hinführt, der durch eine durchgezogene Linie gezeigt ist. Ein solches Signal wird , wie o.a., vom Umsetzer U1 gemäß FIG 1 feinstufig digitalisiert erzeugt. Zwischen dem zu erfassenden Winkel phi der Impulsscheibe I und dem vom Umsetzer U1 ermittelten Signal E besteht damit ein linearer Zusammenhang. Damit in möglichst einfacher Weise jeder Amplitude dieses Folgesignals ein Winkelwert zugeordnet werden kann, der die jeweilige Lage innerhalb des jeweiligen Dreiecksverlaufs anzeigt, kann durch eine der Übersichtlichkeit halber nicht dargestellte Umsetzerschaltung jeder absteigende Signalzug des dreieckförmigen Folgesignals gespiegelt werden, wie dies in der unteren Darstellung gemäß FIG 2 durch eine gestrichelte Linie für den ersten Dreiecksverlauf gezeigt ist.

Für eine Detektion, welche Viertelperiode jeweils momentan relevant ist, kann mit Hilfe von Schwellwertstufen S1 und S2 und einem Umsetzer U4 detektiert werden, wann das Signal A eine positive Polarität und das Signal B eine negative Polarität aufweist, dies deutet auf einen Winkelbereich von 0° bis 90° hin, wann beide Signale eine positive Polarität aufweisen, dies deutet auf einen Winkelbereich von 90° bis 180° hin, wann das Signal B eine positive Polarität aufweist und das Signal A eine negative Polarität aufweist, dies deutet auf einen Winkelbereich von 180° bis 270°, und wann beide Signale eine negative Polarität aufweisen, den dies deutet auf eine Winkellage zwischen 270° und 360° hin. Diese Information kann vom Umsetzer U4 einer Verarbeitungseinrichtung V zugeleitet werden, der auch das Ausgangssignal E des Umsetzers 1 zugeführt wird. Um eine Aussage darüber treffen zu können, welche Achtelperiode vorliegt, ist ferner eine Vergleichseinrichtung VE vorgesehen, der die Signale |A| und |B| zugeleitet werden. In der Vergleichseinrichtung VE wird stets dann ein entsprechendes erste Ausgangssignal generiert, wenn |A|>|B| ist bzw. es wird ein zweites Ausgangssignal generiert, wenn |A|<|B| ist. Beide Ausgangssignale werden dem Umsetzer U4 zugeleitet, der durch logische Verknüpfung mit den Signalen der Schwellwertstufen S1 und S2 ein entsprechendes Achtelperiodensignal für die Verarbeitungseinrichtung V bereitstellt.

In der Darstellung gemäß FIG 2 ist im unteren Diagramm das Folgesignal als eine ideale Dreiecks- bzw. Sägezahnfunktion abgebildet. Strenggenommen liegen jedoch noch geringe Nichtlinearitäten vor. Der hierdurch bedingte Fehler ist für viele Fälle vernachlässigbar, jedoch ist es auch relativ einfach möglich, durch eine angepaßte Übertragungskennlinie des Umsetzers U3 eine weitgehende Kompensation vorzunehmen. Denkbar wäre zwar auch eine direkte Kompensation des Signals E, jedoch müßte diese sich im digitalen Bereich bewegen, was technisch schwieriger zu bewerkstelligen ist, als die Kompensation im analogen Bereich.

Sofern Gebersignalfehler auftreten, d.h. Fehler der Amplitudengleichheit, Phasen- und Offset-Fehler, ergeben sich zwar gegenüber dem Idealfall verschlechterte Meßfehler, jedoch zeigt sich als ein wesentlicher Vorteil, daß der Ausgangscode in jedem Fall vollständig bleibt, d.h. der Verlauf des Signals E erfolgt immer von 0 bis zu einem der Auflösung entsprechenden Wert. Damit bleiben die Kurven monoton. Als Auswirkung der Geberfehler wäre lediglich eine lineare Verzerrung zu verzeichnen, die aber bei der Güte der handelsüblichen Geber innerhalb sehr enger Toleranzen bliebe.

**Patentansprüche**

1. Schaltungsanordnung für ein Gebersystem (GS) für ein erstes (A) und ein zweites weg- oder winkelabhängiges sinusförmiges Signal (B), wobei diese Signale (A,B) zueinander einen Phasenversatz von etwa 90° el. zueinander aufweisen, wobei eine erste (G1) und eine zweite Gleichrichterstufe (G2) vorgesehen sind, wobei das erste Signal (A) die erste (G1) und das zweite Signal (B) die zweite Gleichrichterstufe (G2) speist, wobei die Ausgänge der beiden Gleichrichterstufen (G1,G2) an die Eingänge einer Summierstufe (AS) geschaltet sind und wobei einem quotientenbildenden Umsetzer (U1) als erstes Eingangssignal das Ausgangssignal der Summierstufe (AS) zugeleitet wird, **dadurch gekennzeichnet, daß** dem ersten Umsetzer (U1) als zweites Eingangssignal ein Ausgangssignal (D) eines zweiten Umsetzers (U2) zugeleitet wird, daß der zweite Umsetzer (U2) mit seinen Eingängen an die Ausgänge der Gleichrichterstufen (G1,G2) geschaltet ist und jeweils das kleinere der Gleichrichterstufenausgangssignale (|A|bzw.|B|) als Ausgangssignal (D) durchschaltet, daß der erste Umsetzer (U1) ein Ausgangssignal (E) erzeugt, das dem Quotienten aus dem Ausgangssignal (D) des zweiten Umsetzers (U2) und dem Ausgangssignal (C) der Summierstufe (AS) entspricht, wobei das Ausgangssignal (E) des ersten Umsetzers (U1) demzufolge eine weg- oder winkelabhängige Amplitude während jeweils einer Achtelperiode der sinusförmigen Signale (A,B) aufweist, und daß eine Auswerteschaltung (S1,S2, VE,U4) vorgesehen ist, durch die entsprechend der Polarität der Signale (A,B) des Gebersystems (G) die relevante Teilperiode bestimmbar ist.

2. Schaltungsanordnung nach Anspruch 1, **dadurch gekennzeichnet,** daß verbleibende Nichlinearitäten des resultierenden Folgesignals (E) durch eine Signalumsetzung entsprechend einer der Nichtlinearität angepaßten Kennlinie reduzierbar sind.

3. Schaltungsanordnung nach Anspruch 2, **dadurch gekennzeichnet,** daß die Signalumsetzung vor dem den Quotienten bildenden Umsetzer (U1) erfolgt.

4. Schaltungsanordnung nach einem der vorstehenden Ansprüche, **dadurch gekennzeichnet,** daß das resultierende dreieckförmige Folgesignal (E) durch Spiegelung des jeweils auf- bzw. absteigenden Signalzugs in ein sägezahnförmiges Folgesignal umformbar ist.

**Claims**

1. Circuit arrangement for a sensor system (GS) for a first (A) and a second course-dependent or angle-dependent sinusoidal signal (B), wherein these signals (A,B) have a phase displacement of approximately 90° el. to one another, wherein a first (G1) and a second rectifier stage (G2) are provided, wherein the first signal (A) supplies the first rectifier stage (G1) and the second signal (B) supplies the second rectifier stage (G2), wherein the outputs of the two rectifier stages (G1,G2) are connected to the inputs of a summing stage (AS) and wherein there is supplied to a quotient-forming converter (U1) as first input signal the output signal of the summing stage (AS), characterized in that there is supplied to the first converter (U1) as second input signal an output signal (D) of a second converter (U2), in that the second converter (U2) is connected by its inputs to the outputs of the rectifier stages (G1,G2) and in each case the smaller of the rectifier-stage output signals (|A| or |B|) connects through as output signal (D), in that the first converter (U1) generates an output signal (E) which corresponds with the quotient of the output signal (D) of the second converter (U2) and the output signal (C) of the summing stage (AS), wherein the output signal (E) of the first converter (U1) accordingly has a course-dependent or angle-dependent amplitude during in each case an eighth period of the sinusoidal signals (A,B), and in that an evaluation circuit (S1,S2,VE,U4) is provided, by means of which, corresponding with the polarity of the signals (A,B) of the sensor system (G), the relevant part period can be determined.

2. Circuit arrangement according to claim 1, characterized in that remaining non-linearities of the resulting sequential signal (E) can be reduced by a signal conversion corresponding with a characteristic adapted to the non-linearity.

3. Circuit arrangement according to claim 2, characterized in that the signal conversion takes place in front of the converter (U1) forming the quotient.

4. Circuit arrangement according to one of the above claims, characterized in that the resulting triangular sequential signal (E) can be converted into a saw-tooth sequential signal through reflection of the respectively ascending or descending signal column.

**Revendications**

1. Montage pour un système transmetteur (GS) pour un premier signal sinusoïdal (A) et un second signal sinusoïdal, (B), qui dépendent d'une distance ou d'un angle, ces signaux (A,B) possédant un déphasage réciproque d'environ 90° électriques, et dans lequel il est prévu un premier étage redresseur (G1) et un second étage redresseur (G2), le premier signal (A) alimentant le premier étage redresseur (G1) et le second signal (B) alimentant le second étage redresseur (G2), alors que les sorties des deux étages redresseurs (G1,G2) sont raccordées aux entrées d'un étage additionneur (AS) et que le signal de sortie de l'étage additionneur (AS) est envoyé en tant que premier signal d'entrée à un convertisseur (U1) de formation d'un quotient, caractérisé par le fait qu'un signal de sortie (D) d'un second convertisseur (U2) est envoyé en tant que premier signal d'entrée au premier convertisseur (U1), que le second convertisseur (U2) est raccordé, par ses entrées, aux sorties des étages redresseurs (G1,G2) et que respectivement le plus petit des signaux de sortie ($|A|$ et $|B|$) des étages redresseurs est transmis en tant que signal de sortie (D), que le premier convertisseur (U1) produit un signal de sortie (E) qui correspond au quotient entre le signal de sortie (D) du second convertisseur (U2) et le signal de sortie (C) de l'étage additionneur (AS), le signal de sortie (E) du premier convertisseur (U1) possédant par conséquent une amplitude, qui dépend d'une distance ou d'un angle, pendant respectivement un huitième de la période des signaux sinusoïdaux (A,B), et qu'il est prévu un circuit d'évaluation (S1,S2,VE,U4), au moyen duquel la période partielle pertinente peut être déterminée en fonction de la polarité des signaux (A,B) du système transmetteur (G).

2.  Montage suivant la revendication 1, caractérisé par le fait que des non-linéarités subsistantes du signal de séquence résultant (E) peuvent être réduites au moyen d'une conversion de signaux réalisée conformément à une courbe caractéristique adaptée à la non-linéarité.

3.  Montage suivant la revendication 2, caractérisé par le fait que la conversion de signaux s'effectue en amont du convertisseur (U1) de formation du quotient.

4.  Montage suivant l'une des revendications précédentes, caractérisé par le fait que le signal de séquence triangulaire résultant (E) peut être transformé par symétrisation de la forme respective montante ou descendante du signal en un signal de séquence en dents de scie.

## FIG 1

## FIG

$$c = |A| + |B|$$

$$D = Min\,(|A|,|B|)$$

$$E = 2 \cdot \frac{Min\,(|A|,|B|)}{|A| + |B|} \cdot \text{Auflösung}$$

## FIG 2